# EUROPÄISCHE PATENTSCHRIFT

(11) **EP 1 623 462 B1**
(45) Veröffentlichungstag und Bekanntmachung des Hinweises auf die Patenterteilung: **21.10.2009**
(21) Anmeldenummer: 04727302.4
(22) Anmeldetag: 14.04.2004
(51) Int. Cl.: H01L 27/115, H01L 21/8246, H01L 21/8247

(54) **BITLEITUNGSSTRUKTUR SOWIE VERFAHREN ZU DEREN HERSTELLUNG**
BIT LINE STRUCTURE AND PRODUCTION METHOD THEREFOR
STRUCTURE DE LIGNES DE BITS ET PROCEDE DE PRODUCTION DE CETTE STRUCTURE

(30) Priorität: 14.05.2003 DE 10321740
(43) Veröffentlichungstag der Anmeldung: 08.02.2006
(73) Patentinhaber: Infineon Technologies AG, 81669 München (DE)
(72) Erfinder: KAKOSCHKE, Ronald, 81475 München (DE); SCHULER, Franz, 01109 Dresden (DE); TEMPEL, Georg, 01277 Dresden (DE)
(74) Vertreter: Kindermann, Peter
(86) Internationale Anmeldenummer: PCT/EP2004/050525
(87) Internationale Veröffentlichungsnummer: WO 2004/102666

(56) Entgegenhaltungen:
- EP-A- 1 045 440
- DE-A- 10 062 245
- US-B1- 6 438 030

## Beschreibung

Die vorliegende Erfindung bezieht sich auf eine Bitleitungsstruktur sowie ein Verfahren zu deren Herstellung und insbesondere auf eine Sub-100nm-Bitleitungsstruktur sowie ein zugehöriges Herstellungsverfahren, wie es in einer nicht flüchtigen SNOR-Speicherschaltung zur jeweiligen selektiven Ansteuerung von Source- und Drainleitungen verwendet werden kann.

Bei der Realisierung von Speicherschaltungen unterscheidet man grundsätzlich die Speicherarchitektur, wobei die sogenannten NAND- und NOR-Architekturen am häufigsten vertreten sind. In beiden Architekturen werden beispielsweise sogenannte Eintransistor-Speicherzellen matrixförmig angeordnet und über sogenannte Wort- und Bitleitungen angesteuert.

Während in NAND-Architekturen eine Vielzahl von Schaltelementen bzw. Speicherelementen seriell miteinander verbunden sind und über ein gemeinsames Auswahlgatter bzw. einen Auswahltransistor angesteuert werden, sind die jeweiligen Schaltelemente in NOR-Architekturen parallel bzw. matrixförmig organisiert, wodurch jedes Schaltelement einzeln ausgewählt werden kann.

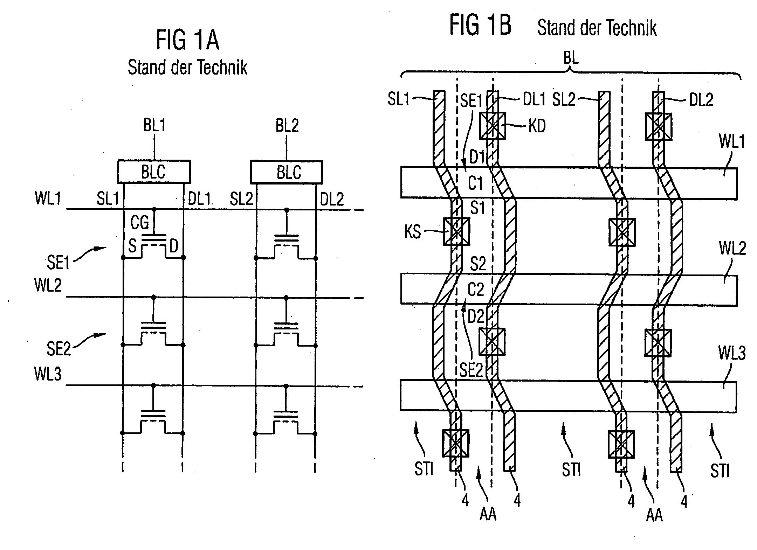

Figur 1A zeigt eine vereinfachte Darstellung einer sogenannten SNOR-Architektur (Selective NOR), bei der im Gegensatz zur NOR-Architektur mit "Common Source"-Aufbau die einzelnen Schaltelemente SE1, SE2, ... selektiv über eine jeweilige Sourceleitung SL1, SL2, ... und über eine jeweilige Drainleitung DL1, DL2, ... angesteuert werden. Diese selektive Ansteuerung wird beispielsweise über jeweilige Bitleitungssteuerungen BLC durchgeführt, welche sozusagen die gemeinsamen Bitleitungen BL1, BL2, ... realisieren. Auf diese Weise können weitere Shrinks bzw. eine weitergehende Integration von Halbleiterschaltungsanordnungen durchgeführt werden, da die SNOR-Architektur nicht auf eine vorbestimmte Mindest-Zelltransistorlänge bzw. Kanallänge angewiesen ist.

Figur 1B zeigt eine vereinfachte Darstellung eines herkömmlichen Layouts der SNOR-Architktur gemäß Figur 1A. Gemäß Figur 1B werden die Schaltelemente bzw. Speicherelemente SE1, SE2, ... in aktiven Bereichen AA eines Halbleitersubstrats ausgebildet, die eine im Wesentlichen gerade streifenförmige Struktur aufweisen. Die Vielzahl von spaltenweise angeordneten streifenförmigen aktiven Bereichen AA werden zeilenweise von ebenfalls streifenförmig ausgebildeten Schichtstapeln bzw. Wortleitungsstapeln WL1, WL2, ... überlagert. Jeder Kreuzungspunkt bzw. Überlappungsbereich eines derartigen streifenförmigen aktiven Bereiches AA mit einem streifenförmig ausgebildeten Wortleitungsstapel WL stellt somit eine Vielzahl von Halbleiterbauelementen bzw. Speicherelementen SE dar.

Zum Kontaktieren von jeweiligen Draingebieten D und Sourcegebieten S sind Kontakte notwendig, die üblicherweise oberhalb der aktiven Bereiche AA ausgebildet sind, oftmals jedoch auch in ein angrenzendes Isolationsgebiet STI (Shallow Trench Isolation) reichen können. In einer weiteren darüber liegenden Schicht, die vorzugsweise eine erste Metallisierungsschicht darstellt, befinden sich nunmehr die Sourceleitungen SL1, SL2, ... sowie die Drainleitungen DL1, DL2, ... für die jeweiligen Bitleitungen BL. Die Drainleitungen stehen hierbei über entsprechende Drainkontakte KD mit den zugehörigen Draingebieten D des aktiven Bereichs AA in Verbindung, wobei in gleicher Weise die Sourceleitungen SL über entsprechende Sourcekontakte KS mit den zugehörigen Sourcegebieten S in Verbindung stehen.

Nachteilig ist jedoch bei einer derartigen herkömmlichen Bitleitungsstruktur, dass auf Grund der zusätzlichen Sourceleitungen im Vergleich zu einer "Common Source"-Architektur eine mehr als doppelt so dichte Metallisierung vorliegt, was einen begrenzenden Faktor für eine weitergehende Integration bzw. weitere Shrinks darstellt.

Zur Verbesserung einer Integrationsdichte wurde daher gemäß Druckschrift DE 100 62 245 A1 vorgeschlagen, die Source- und Drainleitungen als Spacer an einem isolierenden Steg auszubilden und über eine zusätzliche Isolierschicht mit entsprechenden Öffnungen eine Kontaktierung der zugehörigen Source-und Draingebiete zu ermöglichen. Weiterhin ist jedoch der Platzbedarf auf Grund der an der Substratoberflächen ausgebildeten und parallel liegenden Source- und Drainleitungen relativ hoch und verhindert eine weitergehende Integration.

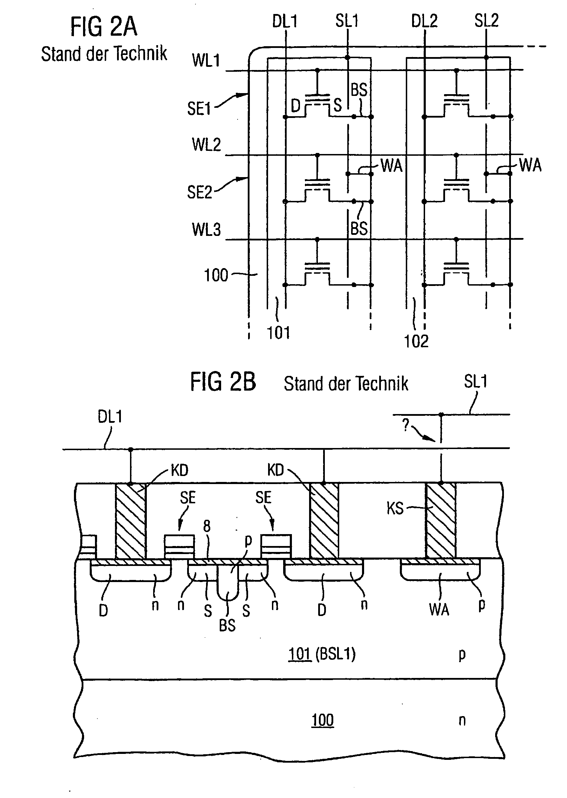

Figuren 2A und 2B zeigen ein vereinfachtes Ersatzschaltbild sowie eine vereinfachte Schnittansicht einer weiteren Bitleitungsstruktur, wie sie beispielsweise aus der Druckschrift US 6,438, 030 B1 bekannt ist.

Gemäß Figuren 2A und 2B ist hierbei wiederum die Drainleitung DL1, DL2, ... als Oberflächen-Bitleitung an einer Oberfläche eines Substrats 100 ausgebildet, in dem voneinander isolierte p-Wannen 101, 102, ... zur Realisierung einer vergrabenen Sourceleitung BSL1 (Buried Source Line) im Halbleitersubstrat ausgebildet sind.

Zur Kontaktierung der jeweiligen Sourcegebiete S mit der vergrabenen Sourceleitung BSL bzw. den p-Wannen 101, 102, ... wird ein sogenannter vergrabener Anschlussstreifen bzw. eine vergrabene Anschlussschicht BS (Buried Strap) in Kontakt mit den Sourcegebieten S als p-Dotiergebiet ausgebildet, welches bis in die p-Wanne 101 reicht. Über eine an der Oberfläche ausgebildete Silizidschicht 8 kann hierbei das Sourcegebiet S mit der vergrabenen Anschlussschicht BS und somit mit der vergrabenen Sourceleitung BSL elektrisch verbunden werden. Auf diese Weise ist jedes Sourcegebiet S der Halbleiterbauelemente SE mit der p-Wanne 101 bzw. der vergrabenen Sourceleitung BSL elektrisch verbunden.

Andererseits sind die Draingebiete D gemäß Figur 2B über Drainkontakte KD mit der Oberflächen-Bitleitung DL1 elektrisch verbunden. Darüber hinaus wird jede p-Wanne bzw. vergrabene Sourceleitung BSL über ein Wannenanschluss-Dotiergebiet WA und einen zugehörigen Sourcekontakt KS mit einer an der Oberfläche geführten Oberflächen-Sourceleitung SL1 elektrisch verbunden. Zur Realisierung ausreichend kleiner Anschlusswiderstände sind derartige Sourcekontakte KS üblicherweise alle 32 bis 64 Zellen im Halbleitersubstrat ausgebildet.

Auf diese Weise kann die Integrationsdichte erheblich verbessert werden, da die Sourceleitung im Wesentlichen als vergrabene Sourceleitung BSL im Halbleitersubstrat ausgebildet ist und die Anforderungen an die Metallisierung an der Substratoberfläche entsprechend entspannt. Nachteilig ist jedoch, dass insbesondere an den Stellen der Sourcekontakte KS auf Grund einer Leitungsüberschneidung zwischen der Oberflächen-Drainleitung DL1 und der Oberflächen-Sourceleitung SL1 weiterhin ein Flächenverlust entsteht.

Der Erfindung liegt daher die Aufgabe zu Grunde, eine Bitleitungsstruktur sowie ein zugehöriges Herstellungsverfahren zu schaffen, welches eine weitere Flächenoptimierung ermöglicht.

Erfindungsgemäß wird diese Aufgabe hinsichtlich der Bitleitungsstruktur durch die Merkmale des Patentanspruchs 1 und hinsichtlich des Verfahrens durch die Maßnahmen des Patentanspruchs, 9 gelöst.

Insbesondere durch die Verwendung eines mit einer elektrisch leitenden Grabenfüllschicht gefüllten Isolationsgrabens zumindest im Bereich des zweiten Kontakts und der daran angrenzenden ersten Kontakte, wobei die Grabenfüllschicht die an den zweiten Kontakt angrenzenden ersten Dotiergebiete zur Realisierung einer vergrabenen Kontakt-Umgehungsleitung miteinander elektrisch verbindet, können die Anforderungen an die Metallisierung weiter entspannt werden, wodurch sich flächenoptimierte Bitleitungsstrukturen realisieren lassen.

Vorzugsweise weist der Isolationsgraben eine an seiner Grabenoberfläche ausgebildete erste Grabenisolierschicht, eine an der Oberfläche der ersten Grabenisolierschicht ausgebildete elektrisch leitende oder nicht leitende Abschirmschicht und eine auf der Oberfläche der Abschirmschicht ausgebildete zweite Grabenisolierschicht auf, wobei sich die Grabenfüllschicht im oberen Abschnitt des Isolationsgrabens befindet, wodurch insbesondere auch für Sub-100nm-Strukturen Halbleiterbauelemente mit hervorragenden elektrischen Eigenschaften und insbesondere Isolationseigenschaften realisiert werden können.

Vorzugsweise befindet sich der zweite Kontakt im Wesentlichen oberhalb der vergrabenen Anschlussschicht, wodurch auf eine zusätzliche Wannen-Kontaktierung verzichtet werden kann und man eine weiter verbesserte Flächenoptimierung erhält.

Insbesondere durch die Verwendung einer selbstjustierenden hochleitfähigen Anschlussschicht können die elektrischen Verbindungen zwischen den ersten oder zweiten Kontakten und den zugehörigen Dotiergebieten sowie der Grabenfüllschicht auf besonders einfache und effektive Weise durchgeführt werden.

Vorzugsweise weist das Substrat ferner ein Wannen-Dotiergebiet auf, in dem das Bitleitungs-Dotiergebiet liegt, wobei der Isolationsgraben über das Wannen-Dotiergebiet hinausragt. Auf diese Weise lassen sich die Isolationseigenschaften zwischen benachbarten Zellen weiter wesentlich verbessern.

In den weiteren Ansprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:
Figuren 1A und 1B ein vereinfachtes Ersatzschaltbild und eine vereinfachte Draufsicht eines Layouts einer herkömmlichen Bitleitungsstruktur in einer SNOR-Speicherschaltung;
Figuren 2A und 2B ein vereinfachtes Ersatzschaltbild und eine zugehörige Schnittansicht einer weiteren herkömmlichen Bitleitungsstruktur;
Figuren 3A und 3B eine vereinfachte Draufsicht eines Layouts und eine zugehörige Schnittansicht entlang eines Schnitts I-I einer Halbleiterschaltung mit einer erfindungsgemäßen Bitleitungsstruktur; und
Figuren 4A bis 9C vereinfachte Schnittansichten der Halbleiterschaltungsanordnung gemäß Figur 3A zur Veranschaulichung wesentlicher Verfahrensschritte bei der Herstellung einer erfindungsgemäßen Bitleitungsstruktur.

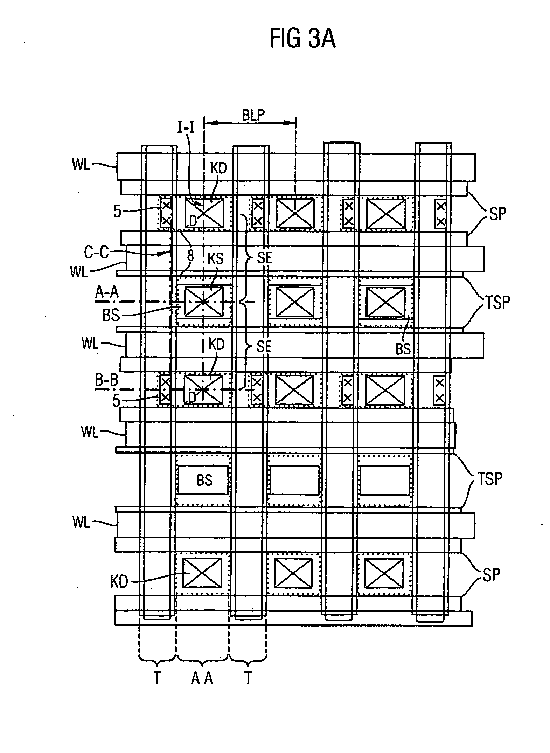

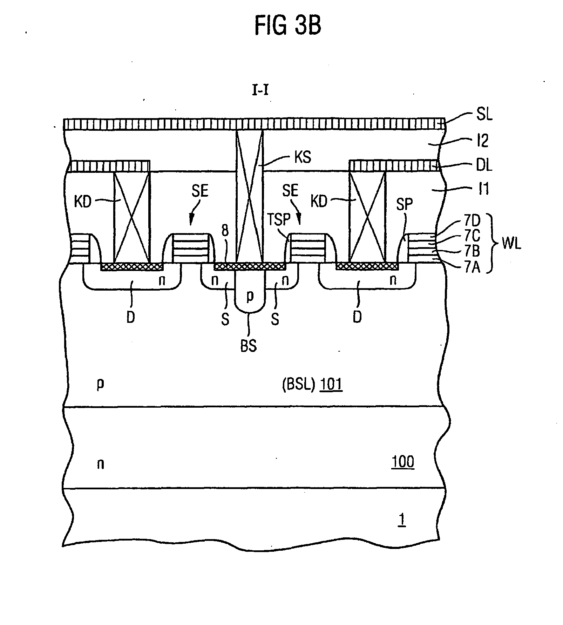

Figuren 3A und 3B zeigen eine vereinfachte Draufsicht eines Layouts einer Halbleiterschaltung sowie eine zugehörige Schnittansicht entlang eines Schnitts I-I zur Veranschaulichung einer erfindungsgemäßen Bitleitungsstruktur, wobei gleiche Bezugszeichen gleiche oder entsprechende Elemente bzw. Schichten bezeichnen wie in Figuren 1A bis 2B, weshalb auf eine wiederholte Beschreibung nachfolgend verzichtet wird.
Figur 3A zeigt hierbei eine vereinfachte Draufsicht eines Layouts einer erfindungsgemäßen Bitleitungsstruktur, wie sie beispielsweise in einer SNOR-Halbleiterspeicherschaltung eingesetzt werden kann.

Gemäß Figuren 3A und 3B werden in einem Substrat 1, welches beispielsweise ein Halbleitersubstrat und vorzugsweise kristallines Silizium aufweist, mittels einer Vielzahl von streifenförmigen Isolationsgräben T eine Vielzahl von streifenförmigen aktiven Gebieten AA spaltenförmig im Substrat ausgebildet. Wie beim Stand der Technik gemäß Figur 1B sind Wortleitungsstapel WL senkrecht zu diesen streifenförmigen aktiven Gebieten AA an der Oberfläche des Substrats zeilenförmig ausgebildet, wobei sie zur Realisierung von beispielsweise nichtflüchtigen Speicherelementen SE als Halbleiterbauelementen eine erste Isolierschicht 7A, wie z.B. eine Gateoxidschicht oder eine Tunnelschicht, eine ladungsspeichernde Schicht 7B, wie z.B. eine Floating-Gate-Schicht, eine zweite Isolierschicht 7C, wie z.B. eine ONO-Schichtenfolge (Oxid/Nitrid/Oxid) und eine Steuerschicht 7D als eigentliche ansteuernde Wortleitung aufweisen.

An den Seitenwänden der Wortleitungsstapel WL sind zu Isolationszwecken Seitenwandisolierschichten bzw. Spacer SP ausgebildet, wobei die zu einem zweiten Kontakt bzw. Sourcekontakt KS zeigenden Spacer bearbeitet bzw. getrimmt sind und eine verringerte Dicke aufweisen. Üblicherweise bestehen diese Spacer SP bzw. getrimmten Spacer TSP aus einer Vielzahl von Spacerschichten, wodurch man eine ausreichende Isolierung und die zugehörigen Anschlussdotiergebiete bzw. eigentlichen ersten und zweiten bzw. Drain- und Source-Dotiergebiete D und S realisieren kann. Auf eine detaillierte Beschreibung dieser Schichten bzw. der zugehörigen Spacer und Dotiergebiete wird an dieser Stelle verzichtet, da sie dem Fachmann ausreichend bekannt sind.

An jedem Kreuzungspunkt bzw. Überlappungspunkt zwischen den aktiven Gebieten AA und den Wortleitungsstapeln WL wird demzufolge ein Halbleiterbauelement bzw. ein nichtflüchtiges Speicherelement SE ausgebildet, welches zur Realisierung einer Feldeffekttransistorstruktur Draingebiete D und Sourcegebiete S als erste und zweite Dotiergebiete von einem ersten Leitungstyp wie z.B. n⁺ an den Seiten der Wortleitungsstapel aufweisen.

Zur Realisierung der erfindungsgemäßen flächenoptimierten Bitleitungsstruktur wird nunmehr zumindest im Bereich des zweiten Kontakts bzw. Sourcekontakts KS und der daran angrenzenden ersten Kontakte bzw. Drainkontakte KD der Isolationsgraben T mit einer elektrisch leitenden Grabenfüllschicht 5 aufgefüllt, welche zur Realisierung einer vergrabenen Kontakt-Umgehungsleitung die an den zweiten Kontakt KS angrenzenden ersten Dotiergebiete D bzw. die angrenzenden ersten Kontakte KD miteinander elektrisch verbindet.

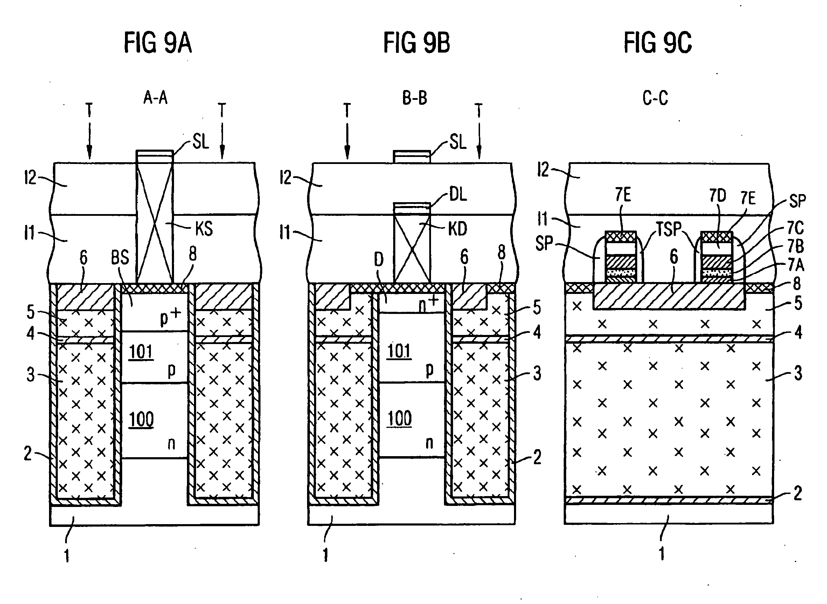

Die Figuren 9A bis 9C zeigen weitere vereinfachte Schnittansichten der Halbleiterschaltungsanordnung gemäß Figur 3A entlang eines Schnitts A-A, B-B und C-C, wobei wiederum gleiche Bezugszeichen gleiche oder entsprechende Schichten bzw. Elemente bezeichnen wie in den Figuren 1 bis 3B und auf eine wiederholte Beschreibung nachfolgend verzichtet wird.

Gemäß dieser Schnittansichten sowie der zugehörigen Draufsicht weist der Isolationsgraben T demzufolge eine an seiner Grabenoberfläche ausgebildete erste Grabenisolierschicht 2, eine an der Oberfläche der ersten Grabenisolierschicht 2 ausgebildete Abschirmschicht 3 und eine auf der Oberfläche der Abschirmschicht 3 ausgebildete zweite Grabenisolierschicht 4 auf, wobei die die vergrabene Kontakt-Umgehungsleitung realisierende Grabenfüllschicht 5 im oberen Abschnitt des Isolationsgraben T ausgebildet ist und mit einer dritten Grabenisolierschicht 6 bis auf freiliegende Anschluss-Bereiche in der Nähe der ersten Kontakte KD abgedeckt ist. Vorzugsweise wird für die Abschirmschicht 3 hochdotiertes polykristallines Halbleitermaterial verwendet, wobei auch andere elektrisch leitende Materialien, wie z.B. Metalle, oder elektrisch nicht leitende Materialien, wie z.B. undotiertes Halbleitermaterial oder Isoliermaterial (SiO₂), grundsätzlich verwendet werden können. Insbesondere Halbleitermaterialien lassen sich hierbei besonders einfach und ohne Ausbildung von unerwünschten Lücken bzw. voids in den tiefen Gräben abscheiden. Diese Abschirmschicht 3 dient demzufolge im Wesentlichen der verbesserten Isolation bzw. Abschirmung zwischen den benachbarten Zellen und verhindert insbesondere das Entstehen von parasitären Transistoren entlang des Grabens in Richtung zum Substrat oder von parasitären Transistoren entlang des Grabens von einem Zellenfeld zum benachbarten Zellenfeld. In gleicher Weise werden dadurch auch Punch-through- bzw. Latch-up-Effekte zuverlässig verhindert.

Im Halbleitersubstrat ist zumindest ein Bitleitungs-Dotiergebiet 101 vom zweiten Leitungstyp p zur Realisierung von zumindest einer vergrabenen Bitleitung BSL wie beim Stand der Technik gemäß Figur 2B ausgebildet und mit den zweiten Dotiergebieten S über vergrabene Anschlussschichten BS vom zweiten Leitungstyp elektrisch miteinander verbunden.

Genauer gesagt werden wie beim Stand der Technik gemäß Figur 2B vorzugsweise mittels Ionenimplantation im Bereich der zweiten Dotiergebiete S derartige vergrabene Anschlussschichten bzw. Buried Straps BS im Bitleitungs-Dotiergebiet bzw. der p-Wanne 101 ausgebildet, wodurch man beispielsweise unter Verwendung einer an der Oberfläche der vergrabenen Anschlussschicht BS und der zweiten Dotiergebiete S selbstjustierend ausgebildeten hochleitfähigen Anschlussschicht 8 einen Kontakt zwischen den Sourcegebieten S und der vergrabenen Sourceleitung BSL bzw. der p-Wanne 101 erhält.

Vorzugsweise werden im Gegensatz zum Stand der Technik gemäß Figur 2B jedoch nunmehr die Sourcekontakte bzw. zweiten Kontakte KS unmittelbar oberhalb der vergrabenen Anschlussschicht BS und ohne Verwendung eines zusätzlichen Wannenanschluss-Dotiergebiets WA in an der Oberfläche ausgebildeten ersten und zweiten Oberflächen-Isolierschichten I1 und I2 ausgebildet, wodurch man bereits eine Flächenoptimierung bzw. einen Flächengewinn erhält. Grundsätzlich können die zusätzlichen Wannenanschluss-Dotiergebiete WA als Bitleitungsanschluss-Dotiergebiete zum Anschließen der Bitleitungs-Dotiergebiete 101 wie beim Stand der Technik gemäß Figur 2B auch beibehalten werden.

Der eigentliche Flächengewinn auf Grund der vergrabenen Kontakt-Umgehungsleitung ergibt sich nämlich aus der Tatsache, dass nunmehr eine als zweite Oberflächen-Bitleitung ausgebildete Sourceleitung SL unmittelbar über einer als erster Oberflächen-Bitleitung ausgebildeten Drainleitung DL zum Liegen kommt und somit ein minimales Maß BLP (Bit Line Pitch) einer minimalen Bitleitungs-Strukturbreite und eines minimalen Bitleitungs-Abstandes realisiert werden kann.

Die erste Oberflächen-Bitleitung DL weist hierbei im Bereich der zweiten Kontakte KS jeweils eine Unterbrechung auf, die durch die im Isolationsgraben T geführte vergrabene Kontakt-Umgehungsleitung ohne einen zusätzlichen Oberflächenbedarf geschlossen wird.

Zur Verbesserung der elektrischen Eigenschaften insbesondere bei Realisierung von Halbleiterschaltungen im Sub-100nm-Bereich wird die dritte Grabenisolierschicht 6 vorzugsweise als flache Grabenisolierschicht mittels eines sogenannten STI-Verfahrens (Shallow Trench Isolation) ausgebildet. Auf diese weise erhält man eine optimale Oberflächenpassivierung des Substrats mit resultierenden verbesserten elektrischen Eigenschaften der im Halbleitersubstrat ausgebildeten Halbleiterbauelemente.

Darüber hinaus kann das Substrat ein Wannen-Dotiergebiet 100 vom ersten Leitungstyp n aufweisen, in dem das Bitleitungs-Dotiergebiet 101 liegt, wobei der Isolationsgraben T über das Wannen-Dotiergebiet 100 hinaus in das Halbleitersubstrat 1 hineinragt. Auf diese Weise erhält man insbesondere für Hochspannungs-Schaltungen hocheffektive Isolationsstrukturen, die insbesondere parasitäre Transistorstrukturen sowie Latch-Up- und Punch-Through-Effekte zuverlässig verhindern. Derartige Bitleitungsstrukturen sind daher insbesondere für Halbleiterschaltungen mit Strukturen im Sub-100nm-Bereich von Bedeutung.

Obwohl insbesondere mittels der vorstehend beschriebenen selbstjustierenden hochleitfähigen Anschlussschicht 8, welche vorzugsweise ein Silizid aufweist, besonders einfach elektrische Verbindungen zwischen den jeweiligen Dotiergebieten und den zugehörigen Kontakten sowie der Grabenfüllschicht 5 realisiert werden können, können derartige Anschlussschichten 8 gemäß einem nicht dargestellten weiteren Ausführungsbeispiel auch unmittelbar durch entsprechend ausgestaltete Kontakte KS und KD realisiert werden.

Demzufolge kann zur Realisierung einer elektrischen Verbindung zwischen den ersten Dotiergebieten D und dem freiliegenden Anschluss-Bereich der Grabenfüllschicht 5 die Bodenfläche des ersten Kontakte KD entsprechend der Fläche der vorstehend beschriebenen Anschlussschicht 8 vom ersten Dotiergebiet D bis zum freiliegenden Anschluss-Bereich der Grabenfüllschicht 5 reichen. In gleicher Weise kann auch der zweite Kontakt KS eine Bodenfläche der vorstehend beschriebenen selbstjustierenden Anschlussschicht 8 aufweisen und somit die zweiten Dotiergebiete S mit der vergrabenen Anschlussschicht BS elektrisch miteinander verbinden. Auf diese Weise erhält man eine Kontaktierung der jeweiligen ersten und zweiten Oberflächen-Bitleitung DL und SL mit den zugehörigen ersten und zweiten Dotiergebieten D und S sowie den vergrabenen Anschlussschichten bzw. der vergrabenen Kontakt-Umgehungsleitung in Abhängigkeit von jeweils zur Verfügung stehenden Standardverfahren.

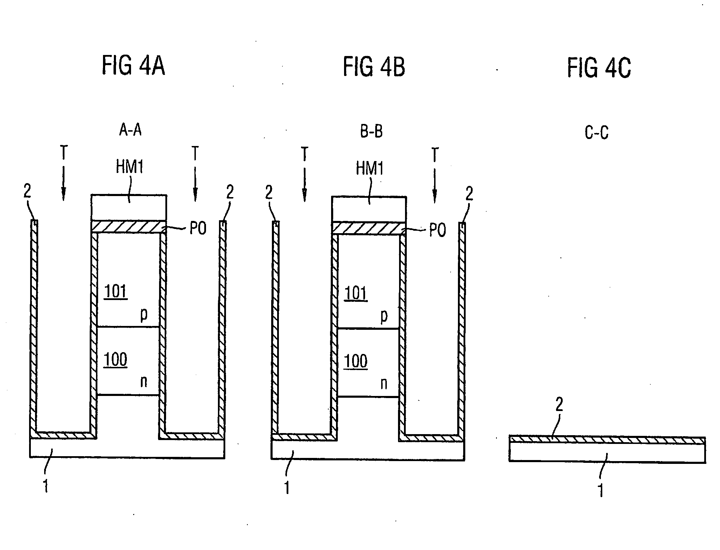

Die Figuren 4A bis 9C zeigen vereinfachte Schnittansichten entlang jeweiliger Schnitte A-A, B-B und C-C zur Veranschaulichung wesentlicher Verfahrensschritte bei der Herstellung einer erfindungsgemäßen Bitleitungsstruktur, wobei gleiche Bezugszeichen wiederum gleiche oder entsprechende Elemente bzw. Schichten bezeichnen wie in den Figuren 1 bis 3B und auf eine wiederholte Beschreibung nachfolgend verzichtet wird.

Gemäß Figuren 4A bis 4C werden demzufolge nach dem Ausbilden eines Wannen-Dotiergebiets 100 vom ersten Leitungstyp n und des Bitleitungs-Dotiergebiets 101 vom zweiten Leitungstyp p im Halbleitersubstrat 1, die vorzugsweise mittels Ionenimplantation durchgeführt wird, zunächst tiefe Isolationsgräben T unter Verwendung einer strukturierten ersten Hartmaskenschicht HM1 und einem darunter liegenden Padoxid PO ausgebildet. Der Isolationsgraben T ragt hierbei vorzugsweise über das Wannen-Dotiergebiet 100 hinaus in das Halbleitersubstrat 1 hinein, wodurch man insbesondere für Hochspannungs-Schaltungen hocheffektive Isolationsstrukturen erhält, die insbesondere parasitäre Transistorstrukturen sowie Latch-Up-und Punch-Through-Effekte zuverlässig verhindern.

Vorzugsweise werden die bei der DRAM-Herstellung verwendeten Verfahren zum Ausbilden von tiefen Isolationsgräben durchgeführt, wobei es sich jedoch nicht um lokal begrenzte Gräben, sondern um langgestreckte isolierende Gräben handelt.

Anschließend wird an der Grabenoberfläche der Isolationsgräben T eine erste Grabenisolierschicht 2 vorzugsweise in Form eines sogenannten Lineroxids beispielsweise thermisch ausgebildet. Während die erste Hartmaske HM1 beispielsweise Si₃N₄ aufweist, wird für die erste Grabenisolierschicht 2 und das Padoxid PO vorzugsweise SiO₂ verwendet.

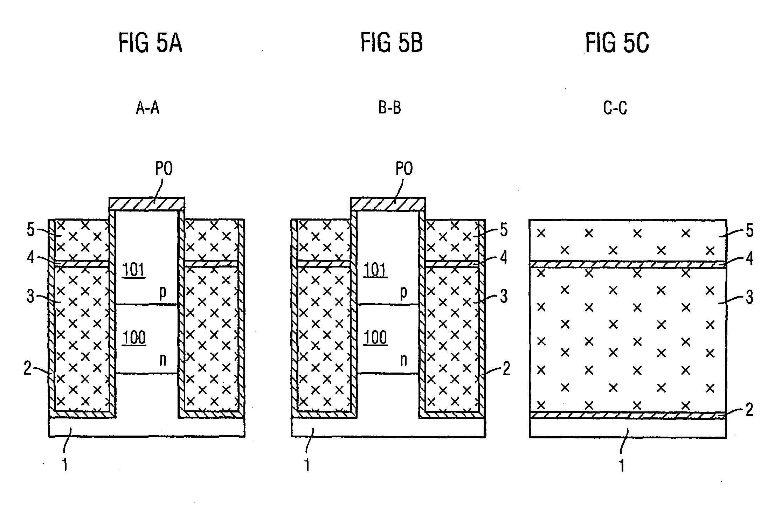

Gemäß Figuren 5A bis 5C wird anschließend eine elektrisch leitende oder nicht leitende Abschirmschicht 3 an der Oberfläche der Grabenisolierschicht 2 in einem unteren Abschnitt des Isolationsgrabens T ausgebildet, wobei vorzugsweise ein vollständiges Auffüllen des Grabens mit beispielsweise hochdotiertem bzw. undotiertem Halbleitermaterial (z.B. Polysilizium) oder einem sonstigen elektrisch leitenden bzw. nicht leitenden Material und ein nachfolgender Rückatzschritt durchgeführt wird.

Anschließend erfolgt das Ausbilden einer zweiten Grabenisolierschicht 4 an der Oberfläche der Abschirmschicht 3, wobei bei Verwendung von Halbleitermaterial für die Abschirmschicht 3 ein Aufwachsen einer Oxidschicht vorzugsweise mittels thermischer Behandlung durchgeführt wird. Zum Ausbilden einer elektrisch leitenden Grabenfüllschicht 5 als vergrabener Kontakt-Umgehungsleitung an der Oberfläche der zweiten Grabenisolierschicht 4, wird beispielsweise ein weiterer Abscheidevorgang zum Auffüllen der Grabenfüllschicht 5 im oberen Abschnitt mittels vorzugsweise hochdotiertem Halbleitermaterial (Polysilizium) durchgeführt und anschließend bis zur Substratoberfläche zurückgeätzt, wobei abschließend die aus Si₃N₄ bestehende erste Hartmaskenschicht HM1 entfernt bzw. gestrippt wird. Wiederum können auch alternative elektrisch leitende Materialien für die Grabenfüllschicht 5 verwendet werden.

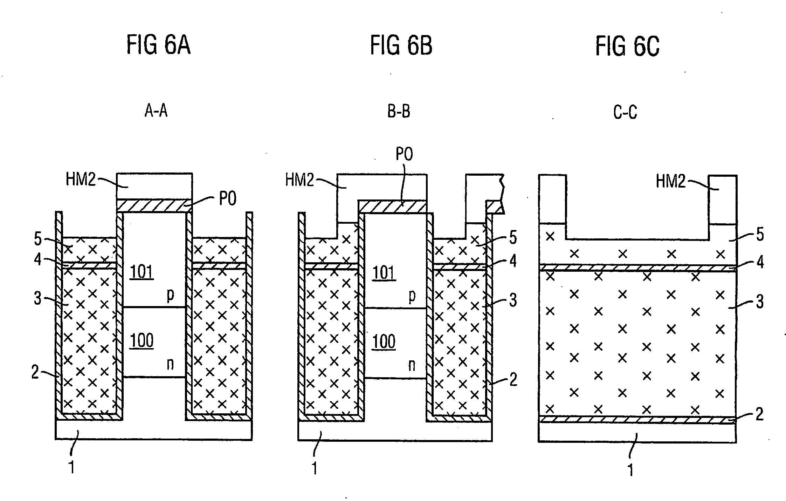

Gemäß Figuren 6A bis 6C wird anschließend unter Verwendung einer zweiten Hartmaskenschicht HM2 beispielsweise mittels eines Standard-STI-Verfahrens ein nicht benötigter Teil der Grabenfüllschicht 5 aus dem oberen Grabenabschnitt entfernt, wobei auch die zweite Hartmaskenschicht wiederum Si₃N₄ aufweist und insbesondere die für die vergrabene Kontakt-Umgehungsleitung vorgesehenen Anschluss-Bereiche der Grabenfüllschicht 5 zumindest teilweise bedeckt. Alternativ kann zu diesem Zeitpunkt ein weiteres Ausbilden einer Oxidschicht in den freigelegten Bereichen durchgeführt werden, wodurch sich ein weiteres Lineroxid in dem freigelegten flachen Graben ergibt.

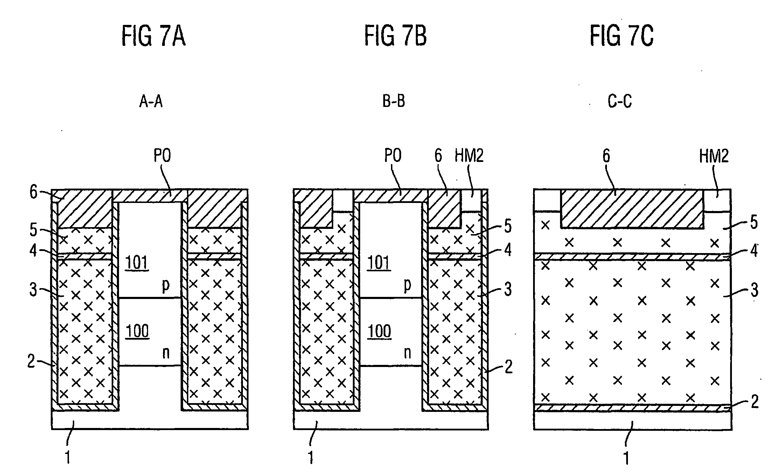

Gemäß Figuren 7A bis 7C erfolgt nunmehr ein sogenanntes "Pullback"-Ätzen der zweiten Hartmaskenschicht HM2, wodurch diese Schicht zum Teil rückgeätzt und die Kanten abgerundet werden. Anschließend erfolgt beispielsweise mittels eines HDP-Verfahrens (High Density Plasma) eine Abscheidung einer dritten Grabenisolierschicht 6 vorzugsweise als flache Grabenisolierung (STI, Shallow Trench Isolation), wodurch der freigelegte obere Abschnitt des Grabens T nunmehr bis auf die durch die verbleibende zweite Hartmaskenschicht HM2 abgedeckten Anschluss-Bereiche der Grabenfüllschicht 5 nunmehr wieder aufgefüllt wird. Zum Entfernen der verbleibenden Pad-Oxidschicht PO sowie der verbleibenden zweiten Hartmaskenschicht HM2 kann beispielsweise ein chemisch-mechanisches Polieren (CMP, Chemical Mechanical Polishing) mit anschließendem HF-Eintauchen (HF-dip) durchgeführt werden.

Ferner kann zu diesem Zeitpunkt in einem nicht dargestellten Oberflächen-Abschnitt des Halbleitersubstrats beispielsweise ein Hochvolt-Dielektrikum und das Entfernen vorzugsweise eines ersten Teils dieses Hochvolt-Dielektrikums auf dem in den Figuren dargestellten relevanten Zellbereich durchgeführt werden.

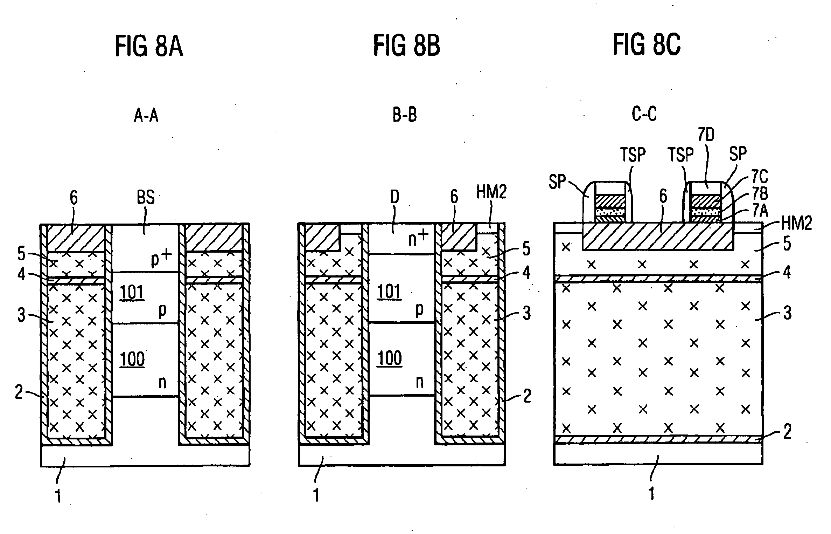

Gemäß Figuren 8A bis 8C erfolgt anschließend wiederum mittels herkömmlicher Verfahren beispielsweise das Ausbilden der Halbleiterbauelemente an der Oberfläche des Substrats, wobei im vorliegenden Fall beispielsweise nichtflüchtige Halbleiterspeicherelemente SE durch Ausbilden und Strukturieren von Wortleitungsstapeln WL mit einer ersten Isolierschicht bzw. einer Tunnelisolierschicht 7A, einer darüber liegenden ladungsspeichernden Schicht 7B, einer darüber liegenden zweiten Isolierschicht bzw. ONO-Schichtenfolge 7C sowie einer abschließenden Steuerschicht 7D realisiert werden.

Ferner werden hierbei die Spacer SP sowie die getrimmten Spacer TSP an den Seitenwänden der streifenförmig ausgebildeten Wortleitungsstapel ausgebildet, mit denen üblicherweise das Ausbilden der ersten und zweiten Dotiergebiete S und D sowie der vergrabenen Anschlussschicht BS vorzugsweise mittels Ionenimplantation durchgeführt wird. In gleicher Weise können hierbei auch nicht dargestellte Spacerstrukturen zur Realisierung von sogenannten Anschluss-Dotiergebieten ausgebildet werden. Gegebenenfalls können ferner zur Realisierung von herkömmlichen Bitleitungsanschluss-Dotiergebieten zum Anschließen des Bitleitungsdotiergebiets 101 beispielsweise auch herkömmliche Wannenanschluss-Dotiergebiete WA wie beim Stand der Technik gemäß Figur 2B ausgebildet werden.

Insbesondere zum Ausbilden der vergrabenen Anschlussschicht BS werden demzufolge die zum zweiten Kontakt KS zeigenden Spacer getrimmt bzw. bearbeitet, wodurch man getrimmte Spacer TSP mit verringerter Dicke erhält. Unter Verwendung dieser getrimmten Spacer TSP kann demzufolge selbstjustierend vorzugsweise mittels Ionenimplantation das Ausbilden der vergrabenen Anschlussschichten BS vom zweiten Leitungstyp durchgeführt werden.

Gemäß Figuren 9A bis 9C werden nach dem Entfernen insbesondere der verbleibenden zweiten Hartmaskenschicht HM2 an den Anschluss-Bereichen der Grabenfüllschicht 5 hochleitfähige Anschlussschichten 8 zum elektrischen Verbinden der ersten und zweiten Dotiergebiete D und S mit der Grabenfüllschicht 5 bzw. der vergrabenen Anschlussschicht BS ausgebildet.

Zum selbstjustierenden Ausbilden der hochleitfähigen Anschlussschichten 8 wird beispielsweise zunächst silizierfähiges Material bzw. eine silizierfähige Metallschicht wie z.B. Kobalt, Nickel oder Platin ganzflächig abgeschieden. Anschließend wird eine Umwandlung der Oberflächenschicht des freiliegenden Halbleitermaterials unter Verwendung des silizierfähigen Materials zum Ausbilden von hochleitfähigen Anschlussbereichen 8 sowie optional von hoch leitfähigen Steuerschichten 7F der Wortleitungsstapel WL durchgeführt, wobei an den nicht mit Halbleitermaterial (Silizium) in Berührung stehenden Oberflächen kein Silizid ausgebildet wird, sondern das abgeschiedene Material (Metall) bestehen bleibt, weshalb wiederum mittels eines vorzugsweise nasschemischen Ätzverfahrens eine selektive Rückätzung der abgeschiedenen - aber nicht silizidierten - Metallschicht erfolgen kann. Auf diese Weise können die hochleitfähigen Anschlussschichten 8 sowie die hochleitfähige Steuerschicht 7F selbstjustierend ausgebildet werden.

Anschließend wird an der Substratoberfläche eine erste Oberflächen-Isolierschicht I1 als Zwischendielektrikum ausgebildet und darin die ersten Kontakte bzw. Drainkontakte KD oberhalb der ersten Dotiergebiete D erzeugt. Die ersten Kontakte KD bestehen vorzugsweise aus zu den Anschlussschichten 8 oberhalb der ersten Dotiergebiete D führenden Kontaktlöchern, (via) in der eine TiN-Schicht vorzugsweise als Barrierenschicht mit einer Wolfram-Schicht als Füllschicht ausgebildet wird. Anschließend wird an der Oberfläche der ersten Oberflächen-Isolierschicht I1 bzw. in einer ersten Metallisierungsebene eine erste Oberflächen-Bitleitung BL ausgebildet, die über die ersten Kontakte KD die ersten Dotiergebiete D kontaktiert.

Anschließend werden an der Oberfläche der ersten Oberflächen-Isolierschicht I1 bzw. der ersten Oberflächen-Bitleitung BL eine zweite Oberflächen-Isolierschicht I2 ausgebildet und wiederum oberhalb der vergrabenen Anschlussschichten BS bis zur zugehörigen hochleitfähigen Anschlussschicht 8 zweite Kontakte bzw. Sourcekontakte KS in der zweiten Oberflächen-Isolierschicht I1, I2 in ähnlicher Weise wie die ersten Kontakte KD ausgebildet. Abschließend wird an der Oberfläche der zweiten Oberflächen-Isolierschicht I2 bzw. in einer zweiten Metallisierungsebene eine elektrisch leitende Schicht ganzflächig abgeschieden und derart strukturiert, dass sich eine zweite Oberflächen-Bitleitung SL ergibt, die über die zweiten Kontakte KS die zweiten Dotiergebiete S kontaktiert.

Auf diese Weise erhält man eine Bitleitungsstruktur mit minimalem Bitleitungsabstand BLP (Bit Line Pitch), wodurch sich eine Flächenoptimierung und verbesserte Integrationsdichten ergeben. Ferner sind auf Grund des besonderen Isolationsaufbaus auch im Sub-100nm-Bereich Halbleiterschaltungen mit hervorragenden elektrischen Eigenschaften zu verwirklichen.

Die Erfindung wurde vorstehend anhand einer nichtflüchtigen SNOR-Halbleiterspeicherschaltung beschrieben. Sie ist jedoch nicht darauf beschränkt und umfasst in gleicher Weise weitere Halbleiterschaltungen, die eine entsprechende Bitleitungsstruktur aufweisen. Ferner ist die Erfindung nicht auf die beschriebenen Silizium-Halbleitersubstrate und zugehörigen Materialien beschränkt, sondern umfasst in gleicher Weise alternative Halbleitermaterialien mit entsprechenden Dotierungen oder Isoliermöglichkeiten. In gleicher Weise können auch die Source- und Draingebiete sowie die zugehörigen Source- und Drainleitungen entsprechend vertauscht werden.

## Patentansprüche

1. Bitleitungsstruktur mit einem Halbleiteraubstrat (1, 100, 101) zur Realisierung einer Vielzahl von Halbleiterbauelementen (SE) mit jeweils einem ersten Dotiergebiet (D) und einem zweiten Dotiergebiet (s) von einem ersten Leitungstyp (n); einem Bitleitungs-Dotiergebiet (101) von einem zum ersten Leitungstyp entgegengesetzten zweiten Leitungstyp (p) zur Realisierung von zumindest einer vergrabenen Bitleitung (BSL), das im Halbleitersubstrat ausgebildet und mit den zweiten Dotiergebieten (S) elektrisch verbunden ist; zumindest einem Isolationsgraben (T), der im Halbleitersubstrat im Wesentlichen parallel zu den vergrabenen Bitleitungen (BSL) zu deren Isolierung ausgebildet ist; einer ersten Oberflächen-Isolierschicht (I1), die an der Oberfläche des Halbleitersubstrats ausgebildet ist; einer ersten Oberflächen-Bitleitung (DL), die an der Oberfläche der ersten Oberflächen-Isolierschicht (I1) ausgebildet und über erste Kontakte (KD) mit den ersten Dotiergebieten (D) elektrisch verbunden ist; einer zweiten Oberflächen-Isolierschicht (I2), die an der Oberfläche der ersten Isolierschicht (I1) und/oder der ersten Oberflächen-Bitleitung (DL) ausgebildet ist; und einer zweiten Oberflächen-Bitleitung (SL), die an der Oberfläche der zweiten Oberflächen-Isolierschicht (I2) ausgebildet und über zumindest einen zweiten Kontakt (KS) mit den zweiten Dotiergebieten (S) elektrisch verbunden ist,
**dadurch gekennzeichnet, dass**
die erste Oberflächen-Bitleitung (DL) eine Unterbrechung im Bereich des zweiten Kontakts (KS) aufweist, und der Isolationsgraben (T) zumindest im Bereich des zweiten Kontakts (KS) und der daran angrenzenden ersten Kontakte (KD) eine elektrisch leitende Grabenfüllschicht (5) aufweist, welche die an dem zweiten Kontakt (KS) angrenzenden ersten Dotiergebiete (D) zur Realisierung einer vergrabenen Kontakt-Umgehungsleitung miteinander elektrisch verbindet.

2. Bitleitungsstruktur nach Patentanspruch 1,
**dadurch gekennzeichnet, dass** der Isolationsgraben (T) eine an seiner Grabenoberfläche ausgebildete erste Grabenisolierschicht (2), eine an der Oberfläche der ersten Grabenisolierschicht (2) ausgebildete elektrisch leitende oder nicht leitende Abschirmschicht (3) und eine auf der Oberfläche der Abschirmschicht (3) ausgebildete zweite Grabenisolierschicht (4) aufweist, auf der die Grabenfüllschicht (5) im oberen Abschnitt des Isolationsgrabens (T) ausgebildet ist.

3. Bitleitungsstruktur nach Patentanspruch 1 oder 2,
**dadurch gekennzeichnet, dass** die zweiten Dotiergebiete (S) mittels zugehöriger vergrabener Anschlussschichten (BS) mit der vergrabenen Bitleitung (BSL) verbunden sind und der zweite Kontakt (KS) im Wesentlichen über einer der vergrabenen Anschlussschichten (BS) oder über Wannenanschluss-Dotiergebieten (WA) zum Anschließen der vergrabenen Bitleitung (BSL) ausgebildet ist.

4. Bitleitungsstruktur nach Patentanspruch 3,
**dadurch gekennzeichnet, dass** der zweite Kontakt (KS) unmittelbar oder mittels einer selbstjustierenden hochleitfähigen Anschlussschicht (8) mit dem zweiten Dotiergebiet (S) und der zugehörigen vergrabenen Anschlussschicht (BS) verbunden ist.

5. Bitleitungsstruktur nach einem der Patentansprüche 1 bis 4, **dadurch gekennzeichnet, dass** an der Oberfläche der Grabenfüllschicht (5) eine flache Grabenisolierschicht (6) ausgebildet ist.

6. Bitleitungsstruktur nach einem der Patentansprüche 1 bis 5, **dadurch gekennzeichnet, dass** die an den zweiten Kontakt (KS) angrenzenden ersten Kontakte (KD) unmittelbar oder mittels einer selbstjustierenden hochleitfähigen Anschlussschicht (8) mit den ersten an den zweiten Kontakt (KS) angrenzenden Dotiergebieten (D) und zugehörigen freiliegenden Anschluss-Bereichen der Grabenfüllschicht (5) verbunden sind.

7. Bitleitungsstruktur nach einem der Patentansprüche 1 bis 6, **dadurch gekennzeichnet, dass** das Substrat ein Wannen-Dotiergebiet (100) aufweist, in dem das Bitleitungs-Dotiergebiet (101) liegt, und der Isolationsgraben (T) über das wannen-Dotiergebiet (100) hinausragt.

8. Bitleitungsstruktur nach einem der Patentansprüche 1 bis 7, **dadurch gekennzeichnet, dass** die Halbleiterbauelemente eine Vielzahl von matrixförmig angeordneten nichtflüchtigen Speicherelementen (SE) mit einer ersten Isolierschicht (7A), einer ladungsspeichernden Schicht (7B), einer zweiten Isolierschicht (7C) und einer Steuerschicht (7D) aufweisen.

9. Verfahren zur Herstellung einer Bitleitungsstruktur zumindest im Bereich eines zweiten Kontakts (KS) und daran angrenzender erster Kontakte (KD) mit den Schritten:
a) Ausbilden eines Bitleitungs-Dotiergebiets (101) in einem Substrat (1, 100);
b) Ausbilden eines Isolationsgrabens (T) im Substrat;
c) Ausbilden einer ersten Grabenisolierschicht (2) an einer Grabenoberfläche des Grabens (T);
d) Ausbilden einer Abschirmschicht (3) an der Oberfläche der Grabenisolierschicht (2) in einem unteren Abschnitt des Isolationsgrabens (T);
e) Ausbilden einer zweiten Grabenisolierschicht (4) an der Oberfläche der Abschirmschicht (3);
f) Ausbilden einer elektrisch leitenden Grabenfüllschicht (5) als vergrabene Kontakt-Umgehungsleitung an der Oberfläche der zweiten Grabenisolierschicht (4);
g) Ausbilden einer dritten Grabenisolierschicht (6) an der Oberfläche der Grabenfüllschicht (5) zumindest im Bereich des zweiten Kontakts (KS);
h) Ausbilden einer Vielzahl von anzuschließenden Halbleiterbauelementen (SE) mit jeweils einem ersten und einem zweiten Dotiergebiet (D, S) an der Oberfläche des Substrats;
i) Ausbilden von zumindest einem Bitleitungsanschluss-Dotiergebiet (BS, WA) zum Anschließen des Bitleitungs-Dotiergebiets (101);
j) Ausbilden einer ersten Oberflächen-Isolierschicht (I1) an der Substratoberfläche;
k) Ausbilden von zumindest an den auszubildenden zweiten Kontakt (KS) angrenzenden ersten Kontakten (KD) in der ersten Oberflächen-Isolierschicht (I1);
l) Ausbilden einer ersten Oberflächen-Bitleitung (DL) an der Oberfläche der ersten Oberflächen-Isolierschicht (I1) derart, dass sie eine Unterbrechung im Bereich des auszubildenden zweiten Kontakts (KS) aufweist;
m) Ausbilden einer zweiten Oberflächen-Isolierschicht (I2) an der Oberfläche der ersten Oberflächen-Isolierschicht (I1) und/oder der ersten Oberflächen-Bitleitung (DL);
n) Ausbilden von zumindest dem zweiten Kontakt (KS) in der ersten und zweiten Oberflächen-Isolierschicht (I1, I2); und
o) Ausbilden einer zweiten Oberflächen-Hitleitung (SL) an der Oberfläche der zweiten Oberflächen-Isolierschicht (I2).

10. Verfahren nach Patentanspruch 9,
**dadurch gekennzeichnet, dass** in Schritt d) elektrisch nicht leitendes oder elektrisch leitendes Material als Abschirmschicht (3) im Isolationsgraben (T) abgeschieden und zurückgeätzt wird.

11. Verfahren nach Patentanspruch 9 oder 10,
**dadurch gekennzeichnet, dass** in Schritt g) die dritte Grabenisolierschicht (6) mittels eines STI-Verfahrens ausgebildet wird.

12. Verfahren nach einem der Patentansprüche 9 bis 11,
**dadurch gekennzeichnet, dass** in Schritt k) die ersten Kontakte (KD) unmittelbar oder mittels einer selbstjustierenden hochleitfähigen Anschlussschicht (8) freiliegende Anschluss-Bereiche der Grabenfüllschicht (5) mit zugehörigen ersten Dotiergebieten (D) verbinden.

13. Verfahren nach einem der Patentansprüche 9 bis 12,
**dadurch gekennzeichnet, dass**
in Schritt i) als Bitleitungsanschluss-Dotiergebiete vergrabene Anschlussschichten (BS) und/oder Wannenanschluss-Dotiergebiete (WA) zum Anschließen der vergrabenen Bitleitung (BSL) ausgebildet werden; und in Schritt n) der zweite Kontakt (KS) unmittelbar oder mittels einer selbstjustierenden hochleitfähigen Anschlussschicht (8) im Wesentlichen über den Bitleitungsanschluss-Dotiergebieten (BS, WA) ausgebildet wird,

14. Verfahren nach Patentanspruch 13,
**dadurch gekennzeichnet, dass**
in Schritt a) kristallines Silizium als Substrat verwendet, in Schritt f) hochdotiertes Polysilizium als zweite Grabenfüllschicht (5) abgeschieden, und als selbstjustierende hochleitfähige Anschlussschicht (8) ein Silizid aus einem silizierfähigen Material umgewandelt wird.

15. Verfahren nach einem der Patentansprüche 9 bis 14,
**dadurch gekennzeichnet, dass** SiO₂ als erste bis dritte Grabenisolierschicht (2, 4, 6) ausgebildet wird.

16. Verfahren nach einem der Patentansprüche 9 bis 15,
**dadurch gekennzeichnet, dass** in Schritt a) ferner ein Wannen-Dotiergebiet (100) vom ersten Leitungstyp (n) im Substrat ausgebildet wird, in dem das Bitleitungs-Dotiergebiet (101) vom zweiten Leitungstyp (p) liegt, und in Schritt b) der Isolationsgraben (T) über das Wannen-Dotiergebiet (100) hinausragt.

17. Verfahren nach einem der Patentansprüche 9 bis 16,
**dadurch gekennzeichnet, dass** die Halbleiterbauelemente eine Vielzahl von matrixförmig ausgebildeten nichtflüchtigen Speicherelementen (SE) mit einer ersten Isolierschicht (7A), einer ladungsspeichernden Schicht (7B), einer zweiten Isolierschicht (7C) und einer Steuerschicht (7D) aufweisen.

## Claims

1. Bit line structure comprising a semiconductor substrate (1, 100, 101) for realizing a multiplicity of semiconductor components (SE) each having a first doping region (D) and a second doping region (S) of a first conduction type (n);
a bit line doping region (101) of a second conduction type (p), which is opposite to the first conduction type, for realizing at least one buried bit line (BSL), which region is formed in the semiconductor substrate and is electrically connected to the second doping regions (S);
at least one isolation trench (2), which is formed in the semiconductor substrate essentially parallel to the buried bit lines (BSL) for the insulation thereof;
a first surface insulating layer (I1), which is formed at the surface of the semiconductor substrate;
a first surface bit line (DL), which is formed at the surface of the first surface insulating layer (I1) and is electrically connected to the first doping regions (D) via first contacts (KD);
a second surface insulating layer (12), which is formed at the surface of the first insulating layer (I1) and/or the first surface bit line (DL); and
a second surface bit line (SL), which is formed at the surface of the second surface insulating layer (I2) and is electrically connected to the second doping regions (S) via at least one second contact (KS),
**characterized in that**
the first surface bit line (DL) has an interruption in the region of the second contact (KS), and
the isolation trench (T) has, at least in the region of the second contact (KS) and the first contacts (KD) adjoining the latter, an electrically conductive trench filling layer (5), which electrically connects to one another the first doping regions (D) adjoining the second contact (KS), for the purpose of realizing a buried contact bypass line.

2. Bit line structure according to Patent Claim 1,
**characterized in that** the isolation trench (T) has a first trench insulating layer (2) formed at its trench surface, an electrically conductive or nonconductive shielding layer (3) formed at the surface of the first trench insulating layer (2), and a second trench insulating layer (4), which is formed on the surface of the shielding layer (3) and on which the trench filling layer (5) is formed in the upper section of the isolation trench (T).

3. Bit line structure according to Patent Claim 1 or 2,
**characterized in that** the second doping regions (S) are connected to the buried bit line (BSL) by means of associated buried connection layers (BS), and the second contact (KS) is formed essentially above one of the buried connection layers (BS) or above well connection doping regions (WA) for the connection of the buried bit line (BSL).

4. Bit line structure according to Patent Claim 3,
**characterized in that** the second contact (KS) is connected to the second doping region (S) and the associated buried connection layer (BS) directly or by means of a self-aligning highly conductive connection layer (8).

5. Bit line structure according to one of Patent Claims 1 to 4, **characterized in that** a shallow trench insulating layer (6) is formed at the surface of the trench filling layer (5).

6. Bit line structure according to one of Patent Claims 1 to 5, **characterized in that** the first contacts (KD) adjoining the second contact (KS) are connected, directly or by means of a self-aligning highly conductive connection layer (8), to the first doping regions (D) adjoining the second contact (KS) and to associated uncovered connection regions of the trench filling layer (5).

7. Bit line structure according to one of Patent Claims 1 to 6, **characterized in that** the substrate has a well doping region (100), in which the bit line doping region (101) is situated, and
the isolation trench (T) projects beyond the well doping region (100).

8. Bit line structure according to one of Patent Claims 1 to 7, **characterized in that** the semiconductor components have a multiplicity of nonvolatile memory elements (SE) arranged in matrix-type fashion and having a first insulating layer (7A), a charge-storing layer (7B), a second insulating layer (7C) and a control layer (7D).

9. Method for the production of a bit line structure at least in the region of a second contact (KS) and first contacts (KD) adjoining the latter, comprising the steps of:
a) forming a bit line doping region (101) in a substrate (1, 100);
b) forming an isolation trench (T) in the substrate;
c) forming a first trench insulating layer (2) at a trench surface of the trench (T);
d) forming a shielding layer (3) at the surface of the trench insulating layer (2) in a lower section of the isolation trench (T);
e) forming a second trench insulating layer (4) at the surface of the shielding layer (3);
f) forming an electrically conductive trench filling layer (5) as buried contact bypass line at the surface of the second trench insulating layer (4);
g) forming a third trench insulating layer (6) at the surface of the trench filling layer (5) at least in the region of the second contact (KS);
h) forming a multiplicity of semiconductor components (SE) to be connected and each having a first and a second doping region (D, S) at the surface of the substrate;
i) forming at least one bit line connection doping region (BS, WA) for the connection of the bit line doping region (101);
j) forming a first surface insulating layer (I1) at the substrate surface;
k) forming at least first contacts (KD) adjoining the second contact (KS) to be formed, in the first surface insulating layer (I1);
l) forming a first surface bit line (DL) at the surface of the first surface insulating layer (I1) in such a way that it has an interruption in the region of the second contact (KS) to be formed;
m) forming a second surface insulating layer (I2) at the surface of the first surface insulating layer (I1) and/or the first surface bit line (DL);
n) forming at least the second contact (KS) in the first and second surface insulating layers (I1; I2); and
o) forming a second surface bit line (SL) at the surface of the second surface insulating layer (I2).

10. Method according to Patent Claim 9,
**characterized in that**, in step d), electrically nonconductive or electrically conductive material is deposited as the shielding layer (3) in the isolation trench (T) and etched back.

11. Method according to Patent Claim 9 or 10,
**characterized in that**, in step g), the third trench insulating layer (6) is formed by means of an STI method.

12. Method according to one of Patent Claims 9 to 11,
**characterized in that**, in step k), the first contacts (KD) connect uncovered connection regions of the trench filling layer (5) to associated first doping regions (D) directly or by means of a self-aligning highly conductive connection layer (8).

13. Method according to one of Patent Claims 9 to 12,
**characterized in that**
step i) involves forming, as bit line connection doping regions, buried connection layers (BS) and/or well connection doping regions (WA) for the connection of the buried bit line (BSL); and
in step n), the second contact (KS) is formed essentially above the bit line connection doping regions (BS, WA) directly or by means of a self-aligning highly conductive connection layer (8).

14. Method according to Patent Claim 13,
**characterized in that**,
in step a), crystalline silicon is used as the substrate,
in step f), highly doped polysilicon is deposited as the second trench filling layer (5), and
a silicide is converted from a silicidable material as the self-aligning highly conductive connection layer (8).

15. Method according to one of Patent Claims 9 to 14,
**characterized in that** SiO₂ is formed as the first to third trench insulating layers (2, 4, 6).

16. Method according to one of Patent Claims 9 to 15,
**characterized in that**, in step a), a well doping region (100) of the first conduction type (n) is furthermore formed in the substrate, in which region the bit line doping region (101) of the second conduction type (p) is situated, and
in step b), the isolation trench (T) projects beyond the well doping region (100).

17. Method according to one of Patent Claims 9 to 16,
**characterized in that** the semiconductor components have a multiplicity of nonvolatile memory elements (SE) formed in matrix-type fashion and having a first insulating layer (7A), a charge-storing layer (7B), a second insulating layer (7C) and a control layer (7D).

## Revendications

1. Structure de lignes de bits comprenant
un substrat (1, 100, 101) semi-conducteur pour la réalisation d'une pluralité de composants (SE) à semi-conducteur, ayant respectivement une première zone (D) de dopage et une deuxième zone (S) de dopage d'un premier type (n) de conductivité ;
une zone (101) de dopage de lignes de bits d'un deuxième type (p) de conductivité opposé au premier type de conductivité, pour la réalisation d'au moins une ligne (BSL) de bits enterrée, qui est constituée dans le substrat semi-conducteur et qui est reliée électriquement à une deuxième zone (S) de dopage ;
au moins un sillon (T) isolant qui est constitué dans le substrat semi-conducteur sensiblement parallèlement aux lignes (BSL) de bits enterrées pour les isoler ;
une première couche (I1) isolante de surface, qui est constituée à la surface du substrat semi-conducteur ;
une première ligne (DL) de bits en surface, qui est constituée à la surface de la première couche (I1) isolante de surface et qui est reliée électriquement à une première zone (D) de dopage par des premiers contacts (KD) ;
une deuxième couche (12) isolante de surface, qui est constituée à la surface de la première couche (I1) isolante et/ou de la première ligne (DL) de bits en surface ; et
une deuxième ligne (SL) de bits en surface, qui est constituée à la surface de la deuxième couche (12) isolante de surface et qui est reliée électriquement aux deuxièmes zones (S) de dopage au moins par un deuxième contact (KS),
**caractérisée en ce que**
la première ligne (DL) de bits en surface a une interruption dans la partie du deuxième contact (KS), et
le sillon (T) isolant a, au moins dans la partie du deuxième contact (KS) et des premiers contacts (KD) qui en sont voisins, une couche (5) conductrice de l'électricité de remplissage de sillon, qui relie électriquement entre elles les premières zones (D) de dopage voisines du deuxième contact (KS) pour la réalisation d'une ligne enterrée de contournement des contacts.

2. Structure de lignes de bits suivant la revendication 1,
**caractérisée en ce que** le sillon (T) isolant a une première couche (2) isolante constituée sur sa surface de sillon, une couche (3) de protection conductrice de l'électricité ou non conductrice de l'électrice constituée à la surface de la première couche (2) isolante de sillon et une deuxième couche (4) isolante de sillon constituée à la surface de la couche (3) de protection, deuxième couche sur laquelle la couche (5) de remplissage de sillon est constituée dans la partie supérieure du sillon (T) isolant.

3. Structure de lignes de bits suivant la revendication 1 ou 2,
**caractérisée en ce que** les deuxièmes zones (S) de dopage sont reliées à la ligne (BSL) de bits enterrée au moyen de couches (BS) de connexion enterrées associées et le deuxième contact (KS) est constitué sensiblement au-dessus de l'une des couches (BS) de connexion enterrées ou sur des zones (WA) de dopage de connexion à caisson pour la connexion de la ligne (BSL) de bits enterrée.

4. Structure de lignes de bits suivant la revendication 3,
**caractérisée en ce que** le deuxième contact (KS) est relié, directement ou au moyen d'une couche (8) de connexion très conductrice à auto-alignement, à la deuxième zone (S) de dopage et à la couche (BS) de connexion enterrée associée.

5. Structure de lignes de bits suivant l'une des revendications 1 à 4,
**caractérisée en ce qu'**une couche (6) isolante de sillon plate est constituée sur la surface de la couche (5) de remplissage de sillon.

6. Structure de lignes de bits suivant l'une des revendications 1 à 5,
**caractérisée en ce que** les premiers contacts (KD) voisins du deuxième contact (KS) sont reliés directement ou au moyen d'une couche (8) de connexion très conductrice à auto-alignement aux premières zones (2) de dopage voisines du deuxième contact (KS) et aux zones de connexion de la couche (5) de remplissage de sillon associées et mises à nu.

7. Structure de lignes de bits suivant l'une des revendications 1 à 6,
**caractérisée en ce que** le substrat a une zone (100) de dopage en caisson, dans laquelle se trouve la zone (101) de dopage de lignes de bits et le sillon (T) isolant dépasse de la zone (100) de dopage en caisson.

8. Structure de lignes de bits suivant l'une des revendications 1 à 7,
**caractérisée en ce que** les composants à semi-conducteur ont une pluralité d'éléments (SE) de mémoire non volatile disposés sous forme de matrice, ayant une première couche (7A) isolante, une couche (7D) d'emmagasinage de charges, une deuxième couche (7C) isolante et une couche (7B) de commande.

9. Procédé de production d'une structure de lignes de bits, au moins dans la partie d'un deuxième contact (KS) et d'un premier contact (KD) qui en sont voisins, comprenant les stades dans lesquels :
a) on forme une zone (101) de dopage de lignes de bits dans un substrat (1, 100) ;
b) on forme un sillon (T) isolant dans le substrat ;
c) on forme une première couche (2) isolante de sillon sur une surface du sillon (T) ;
d) on forme une couche (3) de protection à la surface de la couche (2) isolante de sillon dans une partie inférieure du sillon (T) isolant ;
e) on forme une deuxième couche (4) isolante de sillon à la surface de la couche (3) de protection ;
f) on forme une couche (5) de remplissage de sillon conductrice de l'électricité en tant que ligne enterrée de contournement de contact à la surface de la deuxième couche (4) isolante de sillon ;
g) on forme une troisième couche (6) isolante de sillon à la surface de la couche (5) de remplissage de sillon au moins dans la partie du deuxième contact (KS) ;
h) on forme une pluralité de composants (SE) à semi-conducteur à raccorder ayant respectivement une première et une deuxième zones (D, S) de dopage à la surface du substrat ;
i) on forme au moins une zone (BS, WA) de dopage de connexion de lignes de bits pour la connexion de la zone (101) de dopage de lignes de bits ;
j) on forme une première couche (I1) isolante de surface à la surface du substrat ;
k) on forme, dans la première couche (I1) isolante de surface, au moins des premiers contacts (KD) voisins du deuxième contact (KS) qui se forme ;
l) on forme une première ligne (DL) de bits de surface à la surface de la première couche (I1) isolante de surface de façon à avoir une interruption dans la partie du deuxième contact (KS) qui se forme ;
m) on forme une deuxième couche (12) isolante de surface à la surface de la première couche (I1) isolante de surface et/ou de la première ligne (DL) de bits de surface ;
n) on forme au moins le deuxième contact (KS) dans la première et dans la deuxième couches (I1, 12) isolantes de surface ; et
m) on forme une deuxième ligne (SL) de surface à la surface de la deuxième couche (12) isolante de surface.

10. Procédé suivant la revendication 9,
**caractérisé en ce que**, dans le stade d), on dépose du matériau non conducteur ou conducteur de l'électricité comme couche (3) de protection dans le sillon (T) isolant et on l'attaque en retrait.

11. Procédé suivant la revendication 9 ou 10,
**caractérisé en ce que**, dans le stade g), on forme la troisième couche (6) isolante de sillon au moyen d'un procédé STI.

12. Procédé suivant l'une des revendications 9 à 11,
**caractérisé en ce que**, dans le stade k), on relie les premiers contacts (KD), directement ou au moyen d'une couche (8) de connexion à auto-alignement très conductrice, à des zones de connexion mises à nue de la couche (5) de remplissage de sillon ayant des premières zones (D) de dopage associées.

13. Procédé suivant l'une des revendications 9 à 12,
**caractérisé en ce que**, dans le stade i), on forme comme zone de dopage de connexion de lignes de bits des couches (BS) de connexion enterrées et/ou des zones (WA) de dopage à connexion en caisson pour la connexion de la ligne (BSL) de bits enterrée ; et
dans le stade m), on forme le deuxième contact (KS), directement ou au moyen d'une couche (8) de connexion à auto-alignement très conductrice, sensiblement sur les zones (BS, WA) de dopage de connexion de lignes de bits.

14. Procédé suivant la revendication 13,
**caractérisé en ce que**, dans le stade a), on utilise du silicium cristallin comme substrat, dans le stade f), on dépose du polysilicium très dopé comme deuxième couche (5) de remplissage de sillon, et
on transforme, comme couche (8) de connexion à auto-alignement très conductrice, un siliciure composé d'un matériau apte à être silicié.

15. Procédé suivant l'une des revendications 9 à 14,
**caractérisé en ce qu'**on constitue du SiO₂ comme première à troisième couches (2, 4, 6) isolantes de sillon.

16. Procédé suivant l'une des revendications 9 à 15,
**caractérisé en ce que**, dans le stade a), on forme, en outre, une zone (100) de dopage en caisson du premier type (n) de conductivité dans le substrat, dans lequel se trouve la zone (101) de dopage de lignes de bits du deuxième type (p) de conductivité, et
dans le stade b), le sillon (T) isolant dépasse de la zone (100) de dopage en caisson.

17. Procédé suivant l'une des revendications 9 à 16,
**caractérisé en ce que** les composants à semi-conducteur ont une pluralité d'éléments (SE) de mémoire non volatile constitués sous forme de matrice ayant une première couche (7A) isolante, une couche (7B) d'emmagasinage de charges, une deuxième couche (7C) isolante et une couche (7B) de commande.
